# EUROPEAN PATENT APPLICATION

(11) **EP 3 098 846 A1**
(43) Date of publication of application: **30.11.2016**
(21) Application number: 16171105.6
(22) Date of filing: 24.05.2016
(51) Int. Cl.: H01L 23/367, H02M 1/00

(54) **SEMICONDUCTOR DEVICE**

(30) Priority: 28.05.2015 JP 2015108806
(71) Applicant: JTEKT Corporation, Chuo-ku, Osaka-shi Osaka 542-8502 (JP)
(72) Inventor: HIEDA, Takahito, Osaka-shi, Osaka, 542-8502 (JP); NAKAI, Motoo, Osaka-shi, Osaka, 542-8502 (JP); UCHIDA, Nobuhiro, Osaka-shi, Osaka, 542-8502 (JP); TANI, Naoki, Osaka-shi, Osaka, 542-8502 (JP)
(74) Representative: Winter, Brandl, Fürniss, Hübner, Röss, Kaiser, Polte - Partnerschaft mbB

(57) **Abstract**

In a semiconductor device, a first to a sixth switching elements Tr1 to Tr6 are joined to a second main surface 2b of a substrate 2 with their electrode surfaces 10a facing the second main surface 2b of the substrate 2. Non-electrode surfaces 10b of the switching elements Tr1 to Tr6 are provided with respective heat spreaders 3 joined thereto. Each of the heat spreaders 3 is constituted of a heat spreader main body 31 and a pair of standing portions (gap determination portions) 32, 33. The heat spreader main body 31 is formed in a cuboid having rectangular flat surfaces that are elongated in one direction. The standing portions 32, 33 are standing on both edges of a surface (upper surface) of the heat spreader main body 31.

## Description

### BACKGROUND OF THE INVENTION

### 1. Field of the Invention

The present invention relates to a semiconductor device used for, for example, an inverter circuit of an electric power steering system.

### 2. Description of Related Art

In an inverter circuit of an electric power steering system, switching elements can generate heat abruptly within a short time. For this reason, a heat sink is joined to a back side of a substrate to which switching elements are joined so as to absorb the heat generated by the switching elements. For example, see Japanese Patent Application Publication No. 2009-200525 (JP 2009-200525 A).

Conventionally, vertical semiconductor elements have been commonly used as switching elements. The vertical semiconductor elements are each provided with a drain electrode (collector electrode) on one surface thereof, and with a source electrode (emitter electrode) and a gate electrode (base electrode) on the other surface.

Alternatively, horizontal semiconductor elements may be used as switching elements. The horizontal semiconductor elements are each provided with a drain electrode, a source electrode, and a gate electrode on one surface thereof, and with no electrodes on the other surface. One example of the horizontal semiconductor elements is a switching element made of GaN as a main material. In the horizontal semiconductor element used as a switching element, an area of electrodes provided on the one surface is smaller than that of the drain electrode of the vertical semiconductor element. As a result, the one surface (hereinafter, may be referred to as the electrode surface) of the horizontal semiconductor element on which the electrodes are provided has a greater thermal resistance than the surface of the vertical semiconductor element on which the drain electrode is provided. For this reason, when used as a switching element, the horizontal semiconductor element is required to have a structure in which the electrical connection in the horizontal semiconductor element is performed on the electrode surface and the heat is dissipated from the other surface (hereinafter, may be referred to as the non-electrode surface).

### SUMMARY OF THE INVENTION

An object of the present invention is to provide a semiconductor device that can efficiently dissipate heat, generated by a switching element, from the non-electrode surface of the switching element via a heat spreader, and that can facilitate keeping a constant gap between the heat spreader and a substrate when the heat spreader is joined to the switching element.

According to an aspect of the present invention, a semiconductor device includes:
a substrate having a first main surface and a second main surface;
a switching element that has an electrode surface on which a plurality of electrodes are provided and a non-electrode surface opposite to the electrode surface and provided with no electrodes, and that is a horizontal semiconductor element joined to the substrate, with the electrode surface facing the second main surface of the substrate; and
a heat spreader joined to the non-electrode surface of the switching element.

The heat spreader has a gap determination portion that determines a gap between the heat spreader and the substrate.

In this configuration, since the heat spreader is joined to the non-electrode surface of the switching element, the heat generated in the switching element can be efficiently dissipated from the non-electrode surface of the switching element via the heat spreader. Furthermore, since the heat spreader has the gap determination portion that determines a gap between the heat spreader and the substrate, the gap between the heat spreader and the substrate can be easily kept constant when the heat spreader is joined to the switching element. Accordingly, when a single heat sink is attached to a plurality of heat spreaders for example, the gaps between the heat spreaders and the substrate are constant, and thus the heat sink can be easily attached to the heat spreaders.

The semiconductor device according to the above aspect may further include a heat sink joined to a surface of the heat spreader that is opposite to a surface of the heat spreader joined to the switching element.

In the semiconductor device according to the above aspect, the switching element may include a plurality of switching elements, and the switching elements may be each provided with the heat spreader.

The semiconductor device according to the above aspect may further include a sealing resin that seals the switching element and the heat spreader, except a portion of the heat spreader including the surface of the heat spreader that is opposite to the surface joined to the switching element.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1 is a plan view of a power module to which semiconductor devices according to one embodiment of the present invention are applied, in a state where a substrate is removed;
FIG. 2 is an enlarged sectional view taken along the line II-II of FIG. 1; and
FIG. 3 is an electric circuit diagram showing an inverter circuit.

### DETAILED DESCRIPTION OF EMBODIMENTS

Hereinafter, embodiments of the present invention will be described in detail with reference to the accompanying drawings.

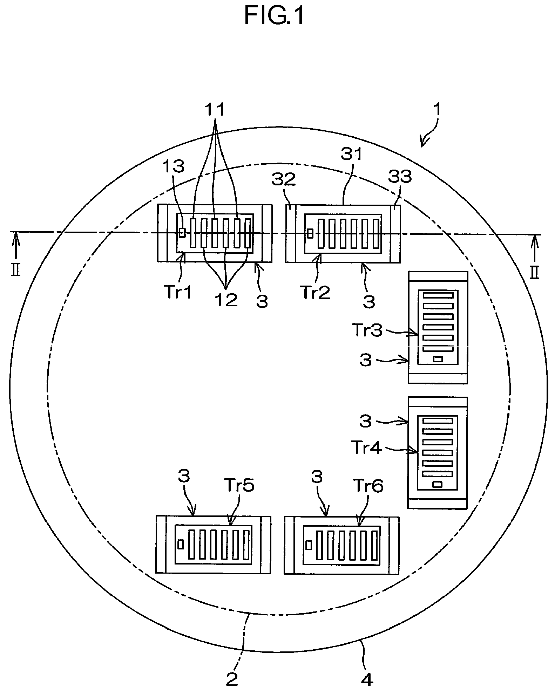

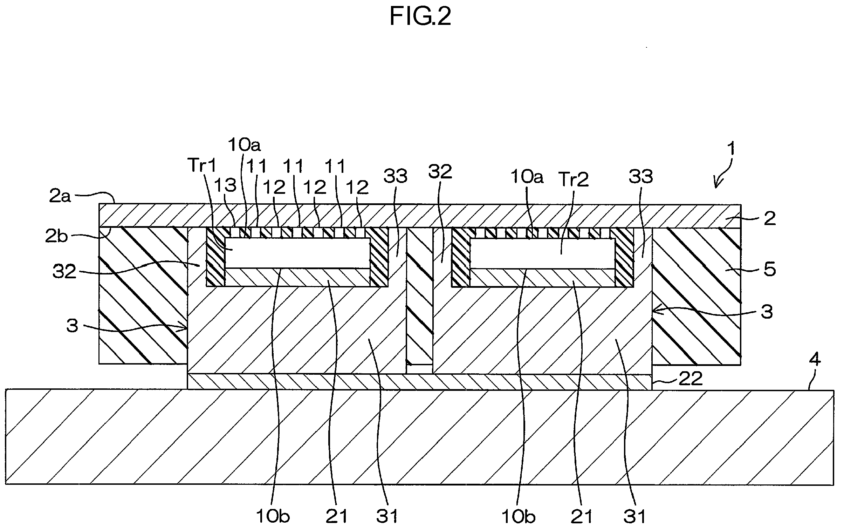

FIG. 1 is a plan view of a power module to which semiconductor devices according to one embodiment of the present invention are applied, in a state where a substrate is removed. FIG. 2 is an enlarged sectional view taken along the line II-II of FIG. 1.

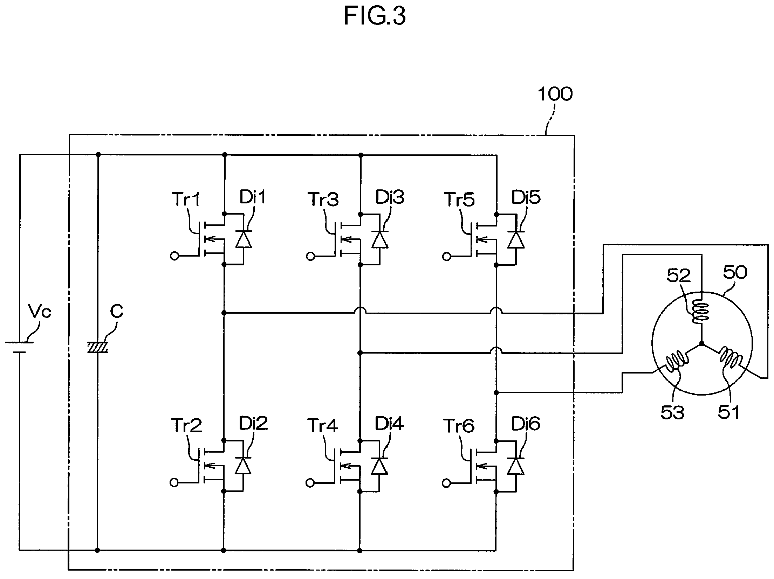

This power module 1 is a module that provides an inverter circuit 100 that is shown in FIG. 3 and used for an electric power steering system (EPS). The inverter circuit 100 shown in FIG. 3 includes a smoothing capacitor C, a plurality of switching elements Tr1 to Tr6, and a plurality of diode elements Di1 to Di6 each connected in antiparallel to a corresponding one of the switching elements Tr1 to Tr6. The smoothing capacitor C is connected between both terminals of a power source Vc.

The switching elements Tr1 to Tr6 are constituted of a first switching element Tr1 which is a U-phase high-side switching element, a second switching element Tr2 which is a U-phase low-side switching element and connected in series with the first switching element Tr1, a third switching element Tr3 which is a V-phase high-side switching element, a fourth switching element Tr4 which is a V-phase low-side switching element and connected in series with the third switching element Tr3, a fifth switching element Tr5 which is a W-phase high-side switching element, and a sixth switching element Tr6 which is a W-phase low-side switching element and connected in series with the fifth switching element Tr5. In this embodiment, each of the switching elements Tr1 to Tr6 is a GaN-FET that is made of GaN as a main material. The first to the sixth switching elements Tr1 to Tr6 are each provided with the corresponding one of the first to the sixth diodes Di1 to Di6 connected in antiparallel thereto.

Drains of the first, third, and fifth switching elements Tr1, Tr3, and Tr5 are connected to the positive terminal of the power source Vc. Sources of the first, third, and fifth switching elements Tr1, Tr3, and Tr5 are respectively connected to drains of the second, fourth, and sixth switching elements Tr2, Tr4, and Tr6. Sources of the second, fourth, and sixth switching elements Tr2, Tr4, and Tr6 are connected to the negative terminal of the power source Vc.

The connection point of the first switching element Tr1 and the second switching element Tr2 is connected to a U-phase stator winding 51 of an electric motor 50. The connection point of the third switching element Tr3 and the fourth switching element Tr4 is connected to a V-phase stator winding 52 of the electric motor 50. The connection point of the fifth switching element Tr5 and the sixth switching element Tr6 is connected to a W-phase stator winding 53 of the electric motor 50. Gates of the switching elements Tr1 to Tr6 are connected to a motor control circuit (not shown).

As shown in FIGS. 1 and 2, the power module 1 includes a substrate 2, the switching elements Tr1 to Tr6, a plurality of heat spreaders 3, and a heat sink 4. The diode elements Di1 to Di6 and the smoothing capacitor C that are included in the power module 1 and shown in FIG. 3 are not shown in FIGS. 1 and 2 for simplifying the description.

In this embodiment, the substrate 2 is formed in a circular shape in a plan view. The substrate 2 may be a ceramic substrate or a glass epoxy substrate. The substrate 2 has a first main surface 2a (upper surface in FIG. 2) and a second main surface 2b (lower surface in FIG. 2) opposite to the first main surface 2a. The first main surface 2a of the substrate 2 is provided with the motor control circuit (not shown) mounted thereon. The second main surface 2b of the substrate 2 is provided with a wiring pattern (not shown) formed thereon to achieve the inverter circuit 100. On the second main surface 2b of the substrate 2, the switching elements Tr1 to Tr6, the diode elements Di1 to Di6 (not shown in FIGS. 1 and 2), and the smoothing capacitor C (not shown in FIGS. 1 and 2) are mounted.

Each of the switching elements Tr1 to Tr6 is formed in a cuboid having rectangular flat surfaces that are longer in one direction. Each of the switching elements Tr1 to Tr6 has the electrode surface (upper surface in FIG. 2) 10a having the plurality of electrodes, and the non-electrode surface (lower surface in FIG. 2) 10b opposite to the electrode surface and having no electrodes. The non-electrode surface 10b of each of the switching elements Tr1 to Tr6 is provided with a metal thin film (not shown) formed thereon.

The electrode surface 10a of each of the switching elements Tr1 to Tr6 is provided with a plurality of drain electrodes 11, a plurality of source electrodes 12, and a single gate electrode 13. Each of the drain electrodes 11 and each of the source electrodes 12 are shaped in a rectangular, in a plan view, that is elongated in the lateral direction of the electrode surface 10a. The plurality of drain electrodes 11 and the plurality of source electrodes 12 are alternately placed at regular intervals in the longitudinal direction of the electrode surface 10a. The gate electrode 13 is formed in a rectangular shape that is almost a square, in a plan view, and is placed at a center of a width portion on one edge side of the electrode surface 10a. Alternatively, the drain electrodes 11 and the source electrodes 12 may be formed like comb teeth so as to face each other.

The first to the sixth switching elements Tr1 to Tr6 are joined to the second main surface 2b of the substrate 2, with their electrode surfaces 10a facing the second main surface 2b of the substrate 2. To be specific, surfaces of the electrodes 11, 12, and 13 of the first to the sixth switching elements Tr1 to Tr6 are joined to the wiring pattern formed on the second main surface 2b of the substrate 2, via solder not shown.

The first switching element Tr1 and the second switching element Tr2 are arranged in a row so that the longitudinal directions of the first switching element Tr1 and the second switching element Tr2 are equal to each other in a plan view. The third switching element Tr3 and the fourth switching element Tr4 are arranged in a row so that the longitudinal directions of the third switching element Tr3 and the fourth switching element Tr4 are equal to each other in a plan view. The fifth switching element Tr5 and the sixth switching element Tr6 are arranged in a row so that the longitudinal directions of the fifth switching element Tr5 and the sixth switching element Tr6 are equal to each other in a plan view. A set of the first and the second switching elements Tr1 and Tr2, a set of the third and the fourth switching elements Tr3 and Tr4, and a set of the fifth and the sixth switching elements Tr5 and Tr6 are disposed in positions corresponding to three of the four sides of a square inscribed in an outer peripheral circle of the substrate 2, in a plan view.

Six metal heat spreaders 3 are provided for the respective six switching elements Tr1 to Tr6. The heat spreaders 3 are joined to the non-electrode surfaces 10b of the switching elements Tr1 to Tr6. In this embodiment, the heat spreaders 3 are made from a material mainly containing cupper. Each of the heat spreaders 3 is constituted of a heat spreader main body 31 and a pair of standing portions 32, 33. The heat spreader main body 31 is formed in a cuboid having rectangular flat surfaces that are elongated in one direction. The standing portions 32, 33 stand on both edges of a surface (upper surface) of the heat spreader main body 31. The length and the width of the surface (upper surface) of the heat spreader main body 31 are greater than the length and the width of the non-electrode surface 10b of the switching elements Tr1 to Tr6, respectively. The non-electrode surface 10b of each of the switching elements Tr1 to Tr6 is joined to a center portion of the surface (upper surface) of the heat spreader main body 31 of the corresponding heat spreader 3 via solder 21.

The length (height) of the standing portions 32, 33 of each of the heat spreaders 3 is slightly greater than a thickness of the switching elements Tr1 to Tr6 including thicknesses of the electrodes 11 to 13. The standing portions 32, 33 of each of the heat spreaders 3 serves as a gap determination portion that keeps a constant gap between the heat spreader main body 31 of the heat spreader 3 and the second main surface 2b of the substrate 2. The ends of the standing portions 32, 33 of each of the heat spreaders 3 abut against the second main surface 2b of the substrate 2. On the second main surface 2b side of the substrate 2, a sealing resin 5 is formed to seal most of the switching elements Tr1 to Tr6 and the heat spreaders 3. In each of the heat spreaders 3, a portion including a surface that is opposite to the surface joined to a corresponding one of the switching elements Tr1 to Tr6 is not sealed by the sealing resin 5 and protrudes outward from the sealing resin 5.

The heat sink 4 is joined to the surfaces of the heat spreaders 3 opposite to the surfaces joined to the switching elements Tr1 to Tr6 via a heat dissipation sheet (thermally conductive sheet) 22. In this embodiment, the heat sink 4 is made of aluminum.

The above-described power module 1 is manufactured, for example, in the following manner. First, the substrate 2 is prepared which includes the first main surface 2a on which the motor control circuit is mounted and the second main surface 2b on which the wiring pattern used to form the inverter circuit 100 is formed. Next, electric components such as the switching elements Tr1 to Tr6 constituting the inverter circuit 100 are joined to the second main surface 2b of the substrate 2. Subsequently, the solder 21 is applied to the non-electrode surfaces 10b of the switching elements Tr1 to Tr6, and then the heat spreaders 3 are joined to the non-electrode surfaces 10b of the switching elements Tr1 to Tr6 with the ends of the standing portions 32, 33 of the heat spreaders 3 pressing against the second main surface 2b of the substrate 2.

After that, the sealing resin 5 is formed on the second main surface 2b side of the substrate 2 so as to seal the switching elements Tr1 to Tr6 and most of the heat spreaders 3. Finally, the heat sink 4 is joined to the surfaces of the heat spreaders 3 opposite to the surfaces joined to the switching elements Tr1 to Tr6 via the heat dissipation sheet 22.

Alternatively, joining of the electric components, such as the switching elements Tr1 to Tr6, to the second main surface 2b of the substrate 2 may be performed at the same time as joining of the heat spreaders 3 to the non-electrode surfaces 10b of the switching elements Tr1 to Tr6.

In the above embodiment, the heat spreaders 3 are joined to the non-electrode surfaces 10b of the switching elements Tr1 to Tr6, and the heat sink 4 is joined to the surfaces of the heat spreaders 3 opposite to the surfaces joined to the switching elements Tr1 to Tr6. This allows efficiently transferring the heat generated in the switching elements Tr1 to Tr6 from the non-electrode surfaces 10b of the switching elements Tr1 to Tr6 to the heat sink4 via the heat spreaders 3. Accordingly, the heat generated in the switching elements Tr1 to Tr6 can be efficiently dissipated from the non-electrode surfaces 10b of the switching elements Tr1 to Tr6.

Furthermore, since each of the heat spreaders 3 has the standing portions 32, 33 (gap determination portions) that determine a gap between each of the heat spreaders 3 and the substrate 2, the gap between the heat spreader main body 31 and the substrate 2 can be easily kept constant when the heat spreaders 3 are joined to the switching elements Tr1 to Tr6. Accordingly, since the gaps between the heat spreaders 3 and the substrate 2 can be kept constant, the heat sink 4 can be easily attached to the heat spreaders 3.

The embodiment of the present invention has been described in the above, but the present invention can also be implemented in other embodiments. As an example, although each of the heat spreaders 3 is provided for each of the switching elements Tr1 to Tr6 in the above embodiment, a single heat spreader may be provided for a plurality of switching elements. That is, a single heat spreader may be joined to a plurality of switching elements. In other words, a plurality of switching elements may be joined to a single heat spreader. For example, two switching elements Tr1 and Tr2 may be joined to a single heat spreader.

Although the single heat spreader 3 has the two standing portions 32, 33 (gap determination portion) in the above embodiment, only one standing portion, or three or more standing portions may be provided for the single heat spreader 3.

Although the inverter circuit 100 is mounted on the main surface 2b of the substrate 2 and the motor control circuit is mounted on the other main surface 2a in the above embodiment, the motor control circuit may be mounted on a substrate other than the substrate 2 on which the inverter circuit 100 is mounted.

The present invention has been described for the case where the invention is applied to the inverter circuit of an electric power steering system. However, the present invention may be applied to other applications, such as an inverter circuit used in a system other than the electric power steering system.

## Claims

1. A semiconductor device comprising:
a substrate having a first main surface and a second main surface;
a switching element that has an electrode surface on which a plurality of electrodes are provided and a non-electrode surface opposite to the electrode surface and provided with no electrodes, and that is a horizontal semiconductor element joined to the substrate with the electrode surface facing the second main surface of the substrate; and
a heat spreader joined to the non-electrode surface of the switching element, wherein
the heat spreader has a gap determination portion that determines a gap between the heat spreader and the substrate.

2. The semiconductor device according to claim 1, further comprising a heat sink joined to a surface of the heat spreader that is opposite to a surface of the heat spreader joined to the switching element.

3. The semiconductor device according to claim 1 or 2, wherein
the switching element includes a plurality of switching elements, and
the switching elements are each provided with the heat spreader.

4. The semiconductor device according to any one of claims 1 to 3, further comprising a sealing resin that seals the switching element and the heat spreader, except a portion of the heat spreader including the surface of the heat spreader that is opposite to the surface joined to the switching element.
